(19) Europäisches Patentamt
European Patent Office
Office européen des brevets

(11) **EP 3 196 695 B1**

(12) **EUROPEAN PATENT SPECIFICATION**

(45) Date of publication and mention
of the grant of the patent:
**04.12.2019 Bulletin 2019/49**

(51) Int Cl.:
*H03M 1/12* *(2006.01)*          *G02F 7/00* *(2006.01)*
*G02F 1/225* *(2006.01)*

(21) Application number: **16151887.3**

(22) Date of filing: **19.01.2016**

(54) **OPTICALLY-ASSISTED TIME-INTERLEAVING DIGITAL-TO-ANALOGUE CONVERTER AND A METHOD USING IT**

OPTISCH UNTERSTÜTZTER DIGITAL-ANALOG-WANDLER MIT ZEITVERSCHACHTELUNG UND VERFAHREN ZUR VERWENDUNG DAVON

CONVERTISSEUR NUMÉRIQUE-ANALOGIQUE À ENTRELACEMENT TEMPOREL ASSISTÉ OPTIQUEMENT ET SON PROCÉDÉ D'UTILISATION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**26.07.2017 Bulletin 2017/30**

(73) Proprietor: **Technische Universität Dresden**
**01069 Dresden (DE)**

(72) Inventors:
• **Khafaji, Mohammad Mahdi**
**01069 Dresden (DE)**
• **Ellinger, Frank**
**01069 Dresden (DE)**
• **Jamshidi, Kambiz**
**01187 Dresden (DE)**

(74) Representative: **Lippert Stachow Patentanwälte Rechtsanwälte**
**Partnerschaft mbB**
**Krenkelstraße 3**
**01309 Dresden (DE)**

(56) References cited:
WO-A1-2009/037418          US-A1- 2007 159 369
US-A1- 2010 201 554          US-A1- 2011 097 085
US-A1- 2013 315 597

**Description**

**Field of the invention**

Digital to analog converters (DAC) are key components to map the data from digital world, in which digital signal processing will be used in computers or microprocessors, etc., to analog world which is the case for sensors, transmitted and received signals in communications, etc. This conversion is necessary whenever mapping from digital signals to analog data is needed. Very high-speed DACs are of high importance in advancing optical communications as well as arbitrary waveform generators.

**State of the art**

Many researchers have been investigated performance parameters of DACs of different technologies and design. Table 1 shows a summary of performance parameters of DACs.

Table I. State-of-the-are DAC designs with higher than 20 GSps.

| Reference | [1] | [2] | [3] | [4] | [5] | [6] |
|---|---|---|---|---|---|---|
| Nominal Res [bits] | 6 | 6 | 6 | 6 | 6 | 6 |
| Mih SFDR [dBc] @ Frequency [GHz] | 29@6.5 | 35@8 | 19@2.5 | - | 30@21 | 30@5.9 |
| Sampling rate [GSps] | 32 | 22 | 20 | 34 | 56 | 28 |
| Power diss. [Watt] | 1.4 | 2 | 0.36 | 3.75 | 0.75 | 1.05 |
| Swing [V] | 0.3 | 0.6 | 0.6 | 1.6 | 0.6 | 0.55 |
| Technology | InP | SiGe | SiGe | SiGe | CMOS | SiGe |
| Process node [um] | 1 | 0.13 | 0.18 | - | 0.065 | 0.25 |
| $f_T$ / $f_{max}$ [GHz] | 175/260 | 150/150 | 150/170 | 170/250 | - | 180/220 |

Where [1] to [6] correspond to the following sources in literature:

[1] M. Nagatani et al. "Ultrahigh-speed low-power DACs using InP HBTs for beyond-100-Gb/s/ch optical transmission systems," IEEE Journal of Solid-State Circuits, vol. 46, no. 10, pp. 2215-2225, Oct. 2011;

[2] P. Schvan et al., "A 22GS/S 6b DAC with integrated digital ramp generator," in Proc. IEEE Int. Solid-State Circuits Conf. Digest of Technical Papers (ISSCC), Feb. 2005,pp. 122-588;

[3] D. Baranauskas et al., "A 0.36W 6b up to 20GS/S DAC for UWB wave formation," in Proc. IEEE Int. Solid-State Circuits Conf. Digest of Technical Papers (ISSCC), Feb. 2006, pp. 2380-2389;

[4] T. Ellermeyer et al., "DA and AD converters in SiGe technology: Speed and resolution for ultra-high data rate applications," in Proc. 36th European Conf Optical Communication (ECOC), Torino, Italy, Sep.2010, pp. 1-6;

[5] Y. M. Greshishchev et al., "A 56GS/S 6b DAC in 65nm CMOS with 256x6b memory," in Proc. IEEE Int. Solid-State Circuits Conf. Digest of Technical Papers (ISSCC), Feb. 2011, pp. 194-196;

[6] M. Khafaji et al., "A 6-bit fully binary digital-to-analogue converter in 0.25-pm SiGe BiCMOS for optical communications," IEEE Transactions on Microwave Theory and Techniques, vol. 59, no. 9, pp. 2254-2264, Sep. 2011.

As it is shown, the resolution of DACs at such high rates could not pass 6-bit barrier and 30 dBc spurious-free dynamic range (SFDR). Spurious-Free Dynamic Range (SFDR) is a crucial specification that is used to characterize the dynamic performance of a signal generator. SFDR specifies the relationship between the amplitude of the fundamental frequency being generated and the amplitude of the most prominent spurious signal or harmonic. In an ideal world, the frequency domain of a pure analog signal has all power concentrated at the desired frequency. However, due to noise and the nonlinearity of components, even the best signal generators also generate frequency content at harmonics (or multiples) of the desired tone. The dynamic range between the fundamental tone and the largest spur is called spurious-free dynamic range. Such specifications are not always enough for emerging applications. In addition to this, being able to improve such a figure opens new multistandard implementations. It can be shown that for a given sampling speed and output voltage swing, the highest achievable SFDR is related to the transit frequency (ft) and the Early voltage of the utilized process. However due to velocity saturation in silicon-based processes, multiplication of these two process parameters does not dramatically increase in newer technology nodes. In M. Khafaji, et al., "SFDR considerations for current steering high-speed digital to analog converters," in IEEE Bipolar/BiCMOS Circuits and Technology Meeting (BCTM), Portland, OR, Sep.2012, pp. 1-4, it could be shown, that the achievable SFDR of a DAC in a given technology and sampling frequency are determined by the Early voltage, the total output swing of the DAC, the transition frequency of a transistor at the unit current ($I_{cell}$) and the sampling frequency. Briefly, this means that one way to improve the SFDR and maintain the sampling rate is to sacrifice the output voltage swing. However the swing cannot be radically decreased to enable an increase in the resolution considering a following circuit such a DAC has to drive.

## Background of the invention

For improving the performance of very high-speed DACs another potential concept like the time-interleaving (TI) concept which is widely used in analog-to-digital converters (ADCs) has been drawn into consideration.

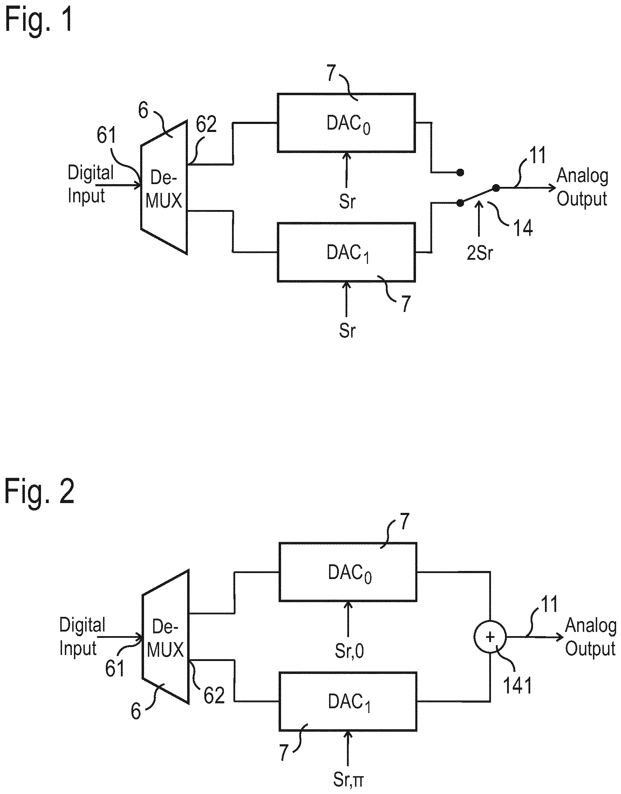

The time-interleaving technique in ADCs is based on parallel functioning of M slower ADC cores, whereas M is the number of ADCs in the system. The system cycles through a set of M sub-ADCs, such that the aggregate throughput is M times the sample rate of the individual sub-ADCs. Therefore, a system with such an architecture enables the sample rate to be pushed further than what is achievable with single channel ADCs, because each core does not need to work at the full Nyquist rate of the input signal. In relation to DACs this means that ideally the outputs of several slower DACs are multiplexed to one output at a higher rate. Analog bandwidth and sampling rate of each DAC can be lower than that of the final output as the switching device performing TI would effectively increase it. A schematic illustration of an ideal time-interleaving concept is shown in figure 1. The digital input is de-multiplexed to two DACs which are sampled with a sampling rate Sr. An ideal switch with a switching speed twice the sampling rate (2 Sr) of the single DACs connects their outputs to the analogue output.

Implementing such an architecture in actual devices is very difficult due to the lack of switching devices with near ideal performance at switching frequencies higher than 20 GHz. This can be observed in state-of-the-art track and hold designs, which are commonly used as switches, and their output bandwidths. One easy implementation of a TI-DAC is to linearly add the output of lower speed DACs, as shown in figure 2. In this case there is a time shift in the sampling clock applied to the DACs. However, this addition is a linear operation and the output bandwidth would still be limited to the one of each DAC. It means while the sampling rate is doubled, the usable output bandwidth is not changed. Another problem in this realization is related to the zero-order hold response of actual DACs which displays a sinc ($\pi f/Sr$) [1] frequency response. One problematic characteristic of this function is that there is a zero at frequency Sr which is the Nyquist frequency of the interleaved DAC. It results in a strong attenuation at any frequency close to this maximum rate.

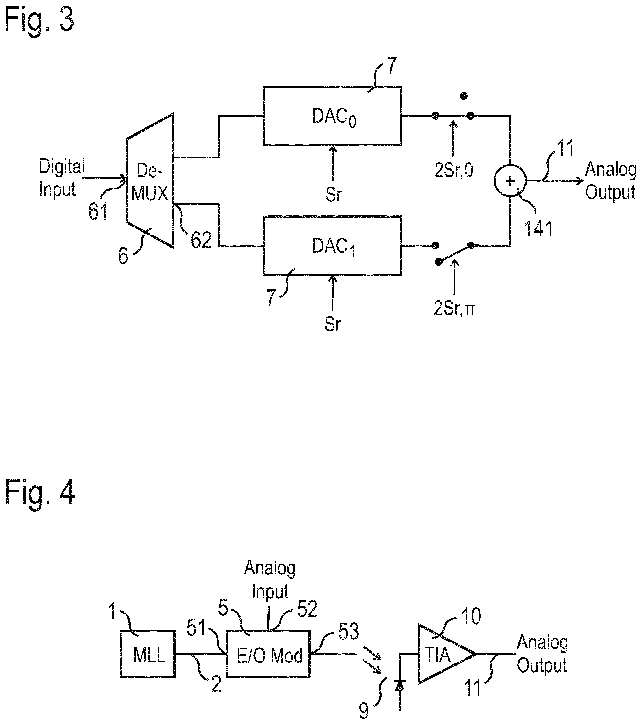

Another implementation is based on return-to-zero addition of each DAC as shown in figure 3. In this case only one low speed DAC is connected to the output at any given time. Ideally this is equivalent to a single DAC running at twice the speed or using an ideal switching device. Unwanted spikes are generated when time alignment is not perfect (see J. Mercado, "DAC Interleaving in Ultra-High-Speed Arbs").

In US 8548331 using the optical sampling to interleave an analog input signal for ADCs has been introduced. Apparently, sampling in optical domain as it is also used in US 2010/201554 A1 is much closer to the ideal switching required in interleaving DACs than the previously described techniques in electrical domain. Figure 4 shows the optical sampling of an analog signal in its basic form. This structure can be considered as a de-glitcher, whereas a de-glitcher can be a nonlinear filter or other special circuit used to limit the duration of switching transients in digital converters. Typically, an external mode locked laser (MLL) is required to produce periodic, low duration optical pulses with a high repetition rate which will be used in the system. Semiconductor MLLs can achieve repetition rates of up to 40 GHz at an amount of jitter as low as 200 fs. Even

[1]

$$sinc(x) = sin(x)/x$$

 higher repetition rates can be achieved by using optical repetition rate multipliers. Lower amounts of jitter as well as higher tuning range can be obtained by using fiber MLLs. The optical pulses can be used to sample an electrical signal by means of an electro-optical modulator (E/O-Mod) like a Mach-Zehnder modulator (MZM). Sampling will be performed by using the output of the MLL as the input signal to the modulator. Bandwidths of around 30 GHz can be achieved using optical modulators in order to map the electrical signals from DACs to the optical signal (see G. T. Reed et al. "Silicon Optical Modulators", Nature Photonics, vol. 4, no. 8, pp.518-527, 2010). Nonlinearities of MZM can also be partially compensated using digital pre-distortion wherever possible. Actually the optical pulses at the output of the MZM are weighted according to an electrical input signal. The optical signal can then be converted back to the electrical domain when a photo detector (PD) is utilized. As the output signal of a PD is normally a small current, a transimpedance amplifier (TIA) is employed to obtain a more suitable signal in the electrical domain.

It is therefore the object of the invention to combine the advantages of optical sampling at high frequency and the interleaving technique to overcome the non-ideal switching performance in digital-to-analogue conversion with increased bandwidth.

The object of the invention will be achieved thereby that a digital-to-analogue converter comprising an optical source having an optical output providing optical signals with a high repetition rate, a first de-multiplexer separating its input to several wavelengths, means adding tunable delay to the several wavelengths, at least one electro optical modulator having an optical input adapted to receive the optical signals of the optical source that are delayed by the means adding tunable delays and an electrical modulation input, whereas the electro optical modulator generating weighted optical pulses from the incident optical signals in response to an analogue modulation signal applied to the electrical modulation input, a second electrical de-multiplexer separating its digital input provided by an electrical signal that is modulated by an electrical clock to more than one digital-to-analogue converter whereas the output of one digital-to-analogue converter is connected to the electrical modulation input of one electro optical modulator, wherein the weighted optical outputs of the electro optical modulators are connected to a multiplexer, multiplexed on one output port and converted into a corresponding electrical analogue signal by a photo detector.

If the optical sampling concept is expanded to interleave the output of different DACs, and combine the optical samples, then a near perfect switch can be implemented. An m-bit DAC at a sampling frequency of $n*f_{in}$ can be implemented by n-times slower DACs and optical interleaving. An optical multiplexer (MUX(O)), a de-multiplexer (De-MUX(O)) and a tunable delay ($\Delta\tau$) are utilized. For multiplexers, various wavelengths in different input ports should be multiplexed on one output port, therefore arrayed waveguide gratings can be used for this purpose. The De-MUX(O) functionality is the inverse of the MUX(O) and it separates its input to several wavelengths. For example, sixteen carriers with frequency spacing of 100GHz can be separated/combined using these devices. To implement an optical tunable delay various schemes based on photonic crystals, coupled ring resonators, and time prism can be used. A tunable delay of up to 100 ps for the input signal with bandwidths of several tens of Giga Hertz can be achieved but this amount of delay can be increased even more.

In a very preferred embodiment all components are integrated on one silicon chip.

The advantage of using electronic photonic integrated components is that the devices will be more efficient in operation, as the integration and miniaturization of circuit structures on one chip or platform allows an increase in switching speeds, through shorter cable lengths, thus achieving shorter signal transit times and lower latencies in the components, and reducing the power consumption of the integrated circuits. Furthermore, the combination and integration of electrical and optical components on one chip allows co-optimizing both the electrical and optical components at the same time.

Moreover, it is beneficial to use integrated devices, which can be easier fabricated in high volumes.

In a further embodiment of the invention the output of the photo detector is connected to a transimpedance amplifier amplifying the electrical signal.

In one embodiment digital filters are connected to the input of the digital-to-analogue converters. It is possible to use the digital filters as pre-distortion and compensate the non-linearity of the system specially the photo detector, electro-optical modulator, and the transimpedance amplifier non-linearity by applying the inverse nonlinear characteristics of these components. Another purpose of the digital filters is to adjust the timing in the system, to compensate for a little variation in the sampling time which is implemented with optical delays. It is also possible to completely omit the optical delays and implement the delay in the electrical domain by delaying the digital samples at the input of digital-to-analogue converters.

In another embodiment of the invention the photo detectors are germanium photo diodes. As an integrated solution, Germanium PDs will be used to convert the optical signal to an electrical signal. The factor, which limits the dynamic range of photodiodes, is their dark current, which would be around 100 nA for Germanium photo detectors. High power levels leads to saturation of photo detectors but it can also be partially compensated using transimpedance amplifiers. Therefore, a dynamic range of more than 40 dB can be expected from these devices. The nonlinearity of photo detectors and transimpedance amplifiers can be compensated by modifying the DAC characteristics, which can be done by digital filtering.

In a further embodiment of the invention a pre-distortion stage is provided at the electrical input of the analogue signal of the electro optical modulator. Whereas in a preferred embodiment the electro optical modulator is a Mach-Zehnder modulator.

Nonlinearities of the modulators can be compensated by pre-distortion of the signal in modulator drivers. Although, this will be at the expense of linearity, it will be possible to achieve maximum achievable bandwidth. If an integrated Mach Zehnder modulator is implemented by diodes, then the exhibited nonlinearity can possibly be compensated by a pre-distortion stage at the electrical input.

An external mode locked laser (MLL) is used to produce periodic large bandwidth, low duration, and optical signals with a high repetition rate. Semiconductor MLLs can achieve repetition rates of up to 40 GHz at an amount of jitter as low as 200 fs. The lower jitter of optical sampling signal compared to that of the electrical domain is another inherit benefit of using an optical sampling signal. This concept enables utilizing higher number of DACs, and interleaving is then limited by the optical loss in the chain.

The object of the invention will be solved also by a method using the novel and inventive claimed optically-assisted time-interleaving Digital-to-Analogue Converter wherein the method comprising the following steps: providing optical signals with a high repetition rate by an optical source, de-multiplexing the optical signals provided by an electrical signal that is modulated by an electrical clock to several wavelengths, adding a tunable delay to said optical signals, de-multiplexing electrical digital signals to several digital-to-analogue converter, converting the electrical digital signals to electrical analogue signals, providing and guiding each of the electrical analogue signals to one analogue input of one electro optical modulator, sampling each of the electrical analogue signal by one of the electro optical modulators using one of the differently generated optical signals, respectively, multiplexing the optically sampled electrical analogue signals by a multiplexer to one output, converting the optical signals to electrical signals by photodetectors; and amplifying the optical-sampled electrical analogue signals by a transimpedance amplifier.

In a preferred embodiment of the method the output of the more than two digital-to-analogue converters are interleaved and optical sampling is used for the time-interleaving.

In a very preferred embodiment of the method the electrical analogue signal is pre-distorted by a pre-distortion stage at the analogue electrical input of the system. Assuming that the Mach-Zehnder modulator that can be used for the electro optical conversion is integrated on a silicon substrate it has characteristics similar to a diode. Therefore, the nonlinearities of the electro optical modulator can be compensated by pre-distortion stage.

The invention will be illustrated by means of embodiments. The corresponding drawings show

Fig. 1    A conceptual schematic of an ideal time-interleaving concept in a DAC;

Fig. 2    Current realization of a TI-DAC by addition the output signals of the single DACs;

Fig. 3    Schematic drawing of the zeroing technique;

Fig. 4    Optical sampling of a DAC output, and then converting it back to an electrical signal. This structure can be considered as a de-glitcher;

Fig. 5    Proposed optical time-interleaving DAC concept according to the invention;

Fig. 6    An example of a currently possible optical time-interleaving DAC with 50 GSps and 8-bit resolution. The required bandwidth and dynamic range for operation are shown as well.

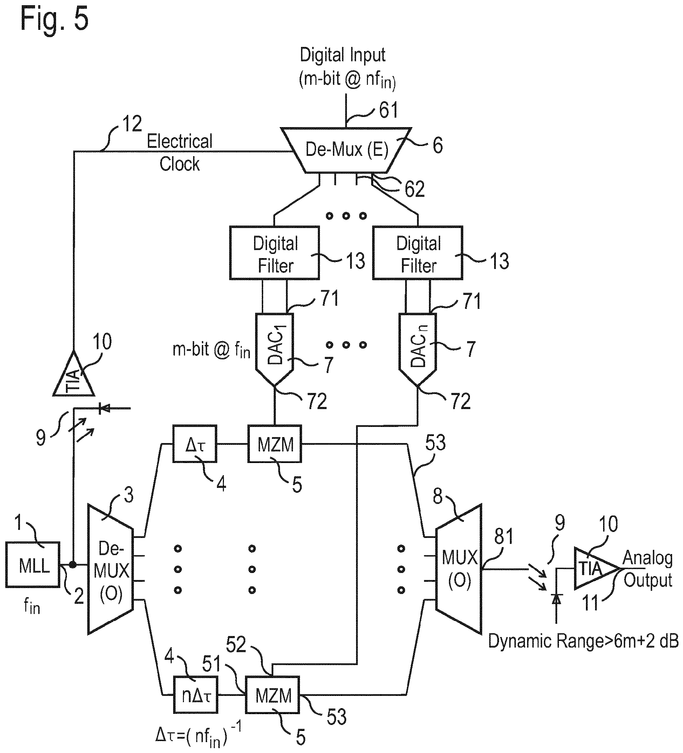

Figure 5 shows the proposed optical time-interleaving digital-to-analogue converter concept according to the invention. The optical sampling concept is expanded to interleave the output 72 of different digital-to-analogue converters 7, and combine the optical samples 53. Therewith a near perfect switch can be implemented. An m-bit digital-to-analogue converter at a sampling frequency of $n*f_{in}$ can be implemented by n-times slower digital-to-analogue converters 7 and optical interleaving is used as shown in figure 5. Here, an optical multiplexer (MUX(O)) 8, a first de-multiplexer (DeMUX(O)) 3 and a tunable delay 4 ($\Delta\tau$) are utilized. For synchronizing the system an electrical clock line 12 is used that connects the output of the optical source with the electrical de-multiplexer 6. The electrical clock is provided by the optical signals generated by the optical source, whereas the optical signal is transformed into an electrical signal by a photo detector 9 and amplified by a transimpedance amplifier 10. Therefor the signals processed by the de-multiplexer 6 and the optical de-multiplexer 3 are synchronized by this clock. For multiplexers 8, various wavelengths in different input ports 53 should be multiplexed on one output port 81, therefore arrayed waveguide gratings can be used for this purpose. The DeMUX(O) 3 functionality is the inverse of the MUX(O) 8 and it separates its input 31 to several wavelengths. For example, sixteen carriers with frequency spacing of 100GHz can be separated/combined using these devices. To implement an optical tunable delay 4 various schemes based on photonic crystals, coupled ring resonators, and time prism have been proposed. A tunable delay 4 of up to 100 ps for the input signal 32 with bandwidths of several tens of GigaHertz have been proposed. But the maximum amount of delay can be increased even more. Another inherit benefit of using an optical sampling signal is the lower jitter of optical sampling signal compared to that of the electrical domain. This concept enables utilizing higher number of digital-to-analogue converters, and interleaving is then limited by the optical loss in the chain. Another advantage is that other than the mode locked laser 1, all other sub-blocks can be integrated on the same silicon die. As an integrated solution, Germanium photo detectors 9 will be used to convert the optical signal to an electrical signal. The factor, which limits the dynamic range of photodiodes, is their dark current, which would be around 100 nA for Germanium photo detectors 9. Therefore, a dynamic range of more than 40 dB can be expected from these devices. High power levels leads to saturation of photo detectors 9 but it can also be partially compensated using transimpedance amplifiers 10. The nonlinearity of photo detectors 9 and transimpedance amplifiers 10 can be compensated by modifying the digital-to-analogue converter characteristics, which can be done by digital filtering 13.

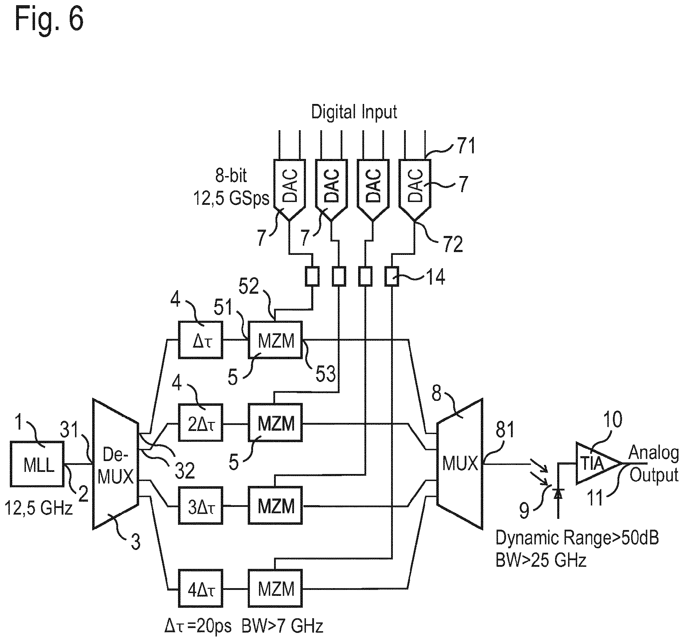

As an example, a possible scenario of an 8-bit digital-to-analogue converter 7 with 50 GSps (Giga Samples per second) based on this concept is presented in figure 6. Four digital-to-analogue converters 7 working at 12.5 GHz are used to convert 8-bit digital signal 71 into four electrical analogue signals 72. Each of the analogue signals 72 are provided at the inputs 52 of one electro optical modulator 5, for example Mach-Zehnder modulator. A mode locked laser 1 is used to produce periodic large bandwidth, low duration, and optical signals with a high repetition rate at its output 2. These optical signals are de-multiplexed to several wavelengths, and a tunable delay 4 is added to each of said optical signals 32. Each of the four electro optical modulator 5 samples each of the electrical analogue signal provided at the output of the four digital-to-analogue converters 72 using one of the differently generated optical signals 32, respectively. These optical sampled time-interleaved electrical signals 53 are multiplexed by a multiplexer 8 to one output 81. This optical output signal 81 is converted to electrical signals by photodetectors 9 and amplified by a transimpedance amplifier 10. Major advantages of the presented idea compared to the fully electrical interleaved digital-to-analogue converter can be summarized as follows:

Firstly, the bandwidth of the system is not limited by the one of each digital-to-analogue converter 7, and therefore it is possible to achieve a bandwidth much higher than that of each digital-to-analogue converter 7. This, in turn, relaxes the electrical sub- digital-to-analogue converter design.

Secondly, as the output 72 is not a direct addition of the sub- digital-to-analogue converters 7, the zeroth-order hold response of each digital-to-analogue converter 7 will not be directly presented at the final output 11.

Thirdly, because of the optical sampling, timing constraints are more relaxed than the zeroing method in figure 3.

Fourthly, considering the current performance of optical components, a medium range resolution (6-8 bits) digital-to-analogue converter 7 can easily be targeted; for which higher sampling rates than the electrical digital-to-analogue converters 7 can be achieved. The resolution is mostly limited by the dynamic range of the output photo detector 9 and transimpedance amplifier 10, so any improvement in this regard leads to a higher resolution digital-to-analogue converter 7 implementation.

Fifthly, at very high frequencies, one of the most important factors deteriorates the SFDR of a digital-to-analogue converter is the glitch caused by its output circuitry (finite output impedance of the digital-to-analogue converter cells). In the proposed structure, due to the optical interpolation which in fact samples the output of each sub-digital-to-analogue converter at a very short instant, a de-glitcher is inherently included. So the SFDR can be higher than a fully electrical DAC even when an electrical de-glitcher (normally track and hold circuit) is considered.

**Optically-Assisted Time-Interleaving Digital-to-Analogue Converter and a method using it**

**Reference numerical list**

| | |
|---|---|
| 1 | optical source |
| 2 | optical output of the optical source |
| 3 | first de-multiplexer |
| 31 | input of the first de-multiplexer |
| 32 | outputs of the first de-multiplexer |
| 4 | tunable delay |
| 5 | electro optical modulator |
| 51 | optical input of the electro optical modulator |
| 52 | electrical input of the electro optical modulator |
| 53 | optical sampled electrical analogue output of the electro optical modulator |
| 6 | second de-multiplexer |
| 61 | digital input of the second de-multiplexer |
| 62 | outputs of the second de-multiplexer |
| 7 | digital-to-analogue converter |

71    input of the digital-to-analogue converter
72    outputs of digital-to-analogue converter
8     multiplexer
81    output of the multiplexer
9     photo detector
10    transimpedance amplifier
11    analogue output
12    electrical clock line
13    digital filter
14    pre-distortion stage
141   adder

**Claims**

1.  Optically-Assisted Time-Interleaving Digital-to-Analogue Converter comprising

    - an optical source (1) having an optical output (2) providing optical signals with a high repetition rate;
    - a first de-multiplexer (3) separating its input (31) to several wavelengths;
    - means adding tunable delays (4) to the several wavelengths;
    - more than one electro optical modulator (5) having an optical input (51) adapted to receive the optical signals of the optical source (1) that are delayed by the means adding tunable delays (4) and an electrical modulation input (52), whereas the electro optical modulator (5) generating weighted optical pulses from the incident optical signals in response to an analogue modulation signal applied to the electrical modulation input (52);

    wherein the weighted optical outputs (53) of the electro optical modulators (5) are connected to a multiplexer (8), multiplexed on one output port (81) and converted into a corresponding electrical analogue signal by a photo detector (9),
    ; **characterized by**

    - a second electrical de-multiplexer (6) separating its digital input (61) provided by an electrical signal that is modulated by an electrical clock provided by the optical signals to more than one digital-to-analogue converter (7) whereas the output of one digital-to-analogue converter (7) is connected to the electrical modulation input (52) of one electro optical modulator (5) .

2.  Optically-Assisted Time-Interleaving Digital-to-Analogue Converter according to claim 1, **wherein** all components are integrated on one silicon chip.

3.  Optically-Assisted Time-Interleaving Digital-to-Analogue Converter according to claim 1 or 2, **wherein** the output of the photo detector (9) is connected to a transimpedance amplifier (19) amplifying the electrical signal.

4.  Optically-Assisted Time-Interleaving Digital-to-Analogue Converter according to one of the foregoing claims, **wherein** the photo detectors (9) are germanium photo diodes.

5.  Optically-Assisted Time-Interleaving Digital-to-Analogue Converter according to claim 1, **wherein** digital filters (13) are connected to the input (71) of the digital-to-analogue converters (7).

6.  Optically-Assisted Time-Interleaving Digital-to-Analogue Converter according to claim 1, **wherein** a pre-distortion stage is provided at the electrical input (52) of the analogue signal of the electro optical modulator (5).

7.  Optically-Assisted Time-Interleaving Digital-to-Analogue Converter according to claim 6, **wherein** the electro optical modulator (5) is a Mach-Zehnder modulator.

8.  Optically-Assisted Time-Interleaving Digital-to-Analogue Converter according to claim 1, **wherein** the optical source (1) is a mode locked laser.

9.  A method of converting an digital signal to an analogue signal using the Digital-to-Analogue Converter according to claims 1 to 8, **wherein** the method comprising:

- providing optical signals (2) with a high repetition rate by an optical source (1);
- de-multiplexing the optical signals (31) to several wavelengths;
- adding a tunable delay (4) to said optical signals (32) ;
- de-multiplexing electrical digital signals (62) provided by an electrical signal that is modulated by an electrical clock provided by the optical signals to several digital-to-analogue converter (7);
- converting the electrical digital signals (71) to electrical analogue signals (52);
- providing and guiding each of the electrical analogue signals (72) to one analogue input (52) of one electro optical modulator (5);
- sampling each of the electrical analogue signal (72) by one of the electro optical modulators (5) using one of the different generated optical signals, respectively;
- multiplexing the optical sampled electrical analogue signals (53) by a multiplexer (8) to one output (81) ;
- converting the optical signals to electrical signals by photodetectors (9); and
- amplifying the optical-sampled electrical analogue signals by a transimpedance amplifier (10).

10. A method of converting a digital signal to an analogue signal according to claim 9, **wherein** the output (72) of the more than two digital-to-analogue converters (7) are interleaved and optical sampling is used for the time-interleaving.

11. A method of converting a digital signal to an analogue signal according to claim 9, **wherein** each of the electrical analogue signals (52) are pre-distorted by a pre-distortion stage (14).

12. A method of converting a digital signal to an analogue signal according to claim 9, **wherein** the pre-distortion stage (14) compensates nonlinearities of the electro optical modulator (5).

**Patentansprüche**

1. Optisch assistierter Zeitverschachtelungs-Digital/Analog-Wandler , folgendes umfassend:

    - eine optische Quelle (1) mit einem optischen Ausgang (2), der optische Signale mit einer hohen Wiederholungsrate bereitstellt;
    - einen ersten Demultiplexer (3), der seinen Eingang (31) in mehrere Wellenlängen trennt;
    - ein Mittel, das abstimmbare Verzögerungen (4) zu den mehreren Wellenlängen hinzufügt;
    - mehr als einen elektrooptischen Modulator (5), der einen optischen Eingang (51), der eingerichtet ist, um die optischen Signale der optischen Quelle (1) zu empfangen, die durch das Mittel verzögert werden, das abstimmbare Verzögerungen (4) hinzufügt, und einen elektrischen Modulationseingang (52) aufweist, während der elektrooptische Modulator (5) gewichtete optische Impulse aus den einfallenden optischen Signalen als Reaktion auf ein analoges Modulationssignal erzeugt, das auf den elektrischen Modulationseingang (52) angewendet wird;

    wobei die gewichteten optischen Ausgänge (53) der elektrooptischen Modulatoren (5) mit einem Multiplexer (8) verbunden sind, auf einem Ausgangsport (81) multiplexiert werden und durch einen Fotodetektor (9) in ein entsprechendes analoges elektrisches Signal umgewandelt werden;
    **gekennzeichnet durch**:

    - einen zweiten elektrischen Demultiplexer (6), der seinen digitalen Eingang (61), der durch ein elektrisches Signal bereitgestellt wird, das durch einen elektrischen Takt moduliert wird, der durch die optischen Signale bereitgestellt wird, an mehr als einen Digital/AnalogWandler (7) trennt, während der Ausgang eines Digital/Analog-Wandler s (7) mit dem elektrischen Modulationseingang (52) eines elektrooptischen Modulators (5) verbunden ist.

2. Optisch assistierter Zeitverschachtelungs-Digital/Analog-Wandler nach Anspruch 1, **wobei** alle Komponenten auf einem Silicium-Chip integriert sind.

3. Optisch assistierter Zeitverschachtelungs-Digital/Analog-Wandler nach Anspruch 1 oder 2, **wobei** der Ausgang des Fotodetektors (9) mit einem Transimpedanzverstärker (19) verbunden ist, der das elektrische Signal verstärkt.

4. Optisch assistierter Zeitverschachtelungs-Digital/Analog-Wandler nach einem der vorangehenden Ansprüche, **wobei** die Fotodetektoren (9) Germanium-Fotodioden sind.

5. Optisch assistierter Zeitverschachtelungs-Digital/Analog-Wandler nach Anspruch 1, **wobei** digitale Filter (13) mit dem Eingang (71) der Digital/AnalogWandler (7) verbunden sind.

6. Optisch assistierter Zeitverschachtelungs-Digital/Analog-Wandler nach Anspruch 1, **wobei** eine Vorverzerrungsstufe an dem elektrischen Eingang (52) des analogen Signals des elektrooptischen Modulators (5) bereitgestellt ist.

7. Optisch assistierter Zeitverschachtelungs-Digital/Analog-Wandler nach Anspruch 6, **wobei** der elektrooptische Modulator (5) ein Mach-Zehnder-Modulator ist.

8. Optisch assistierter Zeitverschachtelungs-Digital/Analog-Wandler nach Anspruch 1, **wobei** die optische Quelle (1) ein modengekoppelter Laser ist.

9. Verfahren zum Umwandeln eines digitalen Signals in ein analoges Signal unter Verwendung des Digital/Analog-Wandler s nach den Ansprüchen 1 bis 8, **wobei** das Verfahren Folgendes umfasst:

- Bereitstellen optischer Signale (2) mit einer hohen Wiederholungsrate durch eine optische Quelle (1);
- Demultiplexieren der optischen Signale (31) in mehrere Wellenlängen;
- Hinzufügen einer abstimmbaren Verzögerung (4) zu den optischen Signalen (32);
- Demultiplexieren digitaler elektrischer Signale (62), die durch ein elektrisches Signal bereitgestellt werden, das durch einen elektrischen Takt moduliert wird, der durch die optischen Signale mehreren Digital/Analog-Wandler n (7) bereitgestellt wird;
- Umwandeln der digitalen elektrischen Signale (71) in analoge elektrische Signale (52);
- Bereitstellen und Führen jedes der analogen elektrischen Signale (72) zu einem analogen Eingang (52) eines elektrooptischen Modulators (5);
- Abtasten jedes der analogen elektrischen Signale (72) durch einen der elektrooptischen Modulatoren (5) unter Verwendung jeweils eines der verschiedenen erzeugten optischen Signale;
- Multiplexieren der optisch abgetasteten analogen elektrischen Signale (53) durch einen Multiplexer (8) an einen Ausgang (81);
- Umwandeln der optischen Signale in elektrische Signale durch Fotodetektoren (9); und
- Verstärken der optisch abgetasteten analogen elektrischen Signale durch einen Transimpedanzverstärker (10) .

10. Verfahren zum Umwandeln eines digitalen Signals in ein analoges Signal nach Anspruch 9, **wobei** die Ausgänge (72) der mehr als zwei Digital/Analog-Wandler (7) verschachtelt sind und ein optisches Abtasten für die Zeitverschachtelung verwendet wird.

11. Verfahren zum Umwandeln eines digitalen Signals in ein analoges Signal nach Anspruch 9, **wobei** jedes der analogen elektrischen Signale (52) durch eine Vorverzerrungsstufe (14) vorverzerrt ist.

12. Verfahren zum Umwandeln eines digitalen Signals in ein analoges Signal nach Anspruch 9, **wobei** die Vorverzerrungsstufe (14) Nichtlinearitäten des elektrooptischen Modulators (5) kompensiert.

**Revendications**

1. Convertisseur numérique-analogique à entrelacement temporel optiquement assisté comprenant

- une source optique (1) ayant une sortie optique (2) fournissant des signaux optiques avec une fréquence de répétition élevée ;
- un premier démultiplexeur (3) séparant son entrée (31) en plusieurs longueurs d'onde ;
- des moyens ajoutant des retards réglables (4) aux longueurs d'onde ;
- plus d'un modulateur électrooptique (5) ayant une entrée optique (51) adaptée pour recevoir les signaux optiques de la source optique (1) qui sont retardés par les moyens ajoutant des retards réglables (4) et une entrée de modulation électrique (52), le modulateur électrooptique (5) générant des impulsions optiques pondérées à partir des signaux optiques incidents en réponse à un signal de modulation analogique appliqué à l'entrée de modulation électrique (52) ;

dans lequel les sorties optiques pondérées (53) des modulateurs électrooptiques (5) sont raccordées à un multiplexeur (8), multiplexées sur un port de sortie (81) et converties en un signal électrique analogique correspondant par un photodétecteur (9) ;
**caractérisé par**

- un deuxième démultiplexeur électrique (6) séparant son entrée numérique (61) fournie par un signal électrique qui est modulé par une horloge électrique fournie par les signaux optiques vers plus d'un convertisseur numérique-analogique (7), la sortie d'un convertisseur numérique-analogique (7) étant raccordée à l'entrée de modulation électrique (52) d'un modulateur électrooptique (5).

2. Convertisseur numérique-analogique à entrelacement temporel optiquement assisté selon la revendication 1, **dans lequel** tous les composants sont intégrés sur une puce en silicium.

3. Convertisseur numérique-analogique à entrelacement temporel optiquement assisté selon la revendication 1 ou 2, **dans lequel** la sortie du photodétecteur (9) est raccordée à un amplificateur à transimpédance (19) amplifiant le signal électrique.

4. Convertisseur numérique-analogique à entrelacement temporel optiquement assisté selon une des revendications précédentes, **dans lequel** les photodétecteurs (9) sont des photodiodes en germanium.

5. Convertisseur numérique-analogique à entrelacement temporel optiquement assisté selon la revendication 1, **dans lequel** des filtres numériques (13) sont raccordés à l'entrée (71) des convertisseurs numérique-analogique (7) .

6. Convertisseur numérique-analogique à entrelacement temporel optiquement assisté selon la revendication 1, **dans lequel** un étage de prédistorsion est prévu à l'entrée électrique (52) du signal analogique du modulateur électrooptique (5).

7. Convertisseur numérique-analogique à entrelacement temporel optiquement assisté selon la revendication 6, **dans lequel** le modulateur électrooptique (5) est un modulateur Mach-Zehnder.

8. Convertisseur numérique-analogique à entrelacement temporel optiquement assisté selon la revendication 1, **dans lequel** la source optique (1) est un laser à verrouillage de mode.

9. Procédé de conversion d'un signal numérique en un signal analogique au moyen du convertisseur numérique-analogique selon les revendications 1 à 8, **dans lequel** le procédé comprend :

- la fourniture de signaux optiques (2) avec une fréquence de répétition élevée par une source optique (1) ;
- le démultiplexage des signaux optiques (31) en plusieurs longueurs d'onde ;
- l'ajout d'un retard réglable (4) auxdits signaux optiques (32) ;
- le démultiplexage de signaux électriques numériques (62) fournis par un signal électrique qui est modulé par une horloge électrique fournie par les signaux optiques vers plusieurs convertisseurs numérique-analogique (7) ;
- la conversion des signaux électriques numériques (71) en signaux électriques analogiques (52) ;
- la fourniture et le guidage de chacun des signaux électriques analogiques (72) jusqu'à une entrée analogique (52) d'un modulateur électrooptique (5) ;
- l'échantillonnage de chacun des signaux électriques analogiques (72) par un des modulateurs électrooptiques (5) au moyen d'un des différents signaux optiques générés, respectivement ;
- le multiplexage des signaux électriques analogiques échantillonnés optiquement (53) par un multiplexeur (8) vers une sortie (81) ;
- la conversion des signaux optiques en signaux électriques par des photodétecteurs (9) ; et
- l'amplification des signaux électriques analogiques échantillonnés optiquement par un amplificateur à transimpédance (10).

10. Procédé de conversion d'un signal numérique en un signal analogique selon la revendication 9, **dans lequel** les sorties (72) des plus de deux convertisseurs numérique-analogique (7) sont entrelacées et un échantillonnage optique est utilisé pour l'entrelacement temporel.

11. Procédé de conversion d'un signal numérique en un signal analogique selon la revendication 9, **dans lequel** chacun des signaux électriques analogiques (52) est prédistordus par un étage de prédistorsion (14).

12. Procédé de conversion d'un signal numérique en un signal analogique selon la revendication 9, **dans lequel** l'étage de prédistorsion (14) compense des non-linéarités du modulateur électrooptique (5).

EP 3 196 695 B1

Fig. 1

Fig. 2

12

Fig. 3

Fig. 4

## Fig. 5

# Fig. 6

Digital Input

8-bit
12,5 GSps

DAC ~71
DAC ~7
DAC
DAC ~72

7 7 14

4 52
51
Δτ — MZM 53
5

4
2Δτ — MZM
5

1 31
MLL — De-
MUX
12,5 GHz 2
3
32

3Δτ — MZM

4Δτ — MZM

Δτ=20ps  BW>7 GHz

8
81
MUX

10
9 TIA
Analog
Output
11

Dynamic Range>50dB
BW>25 GHz

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 8548331 B

- US 2010201554 A1

### Non-patent literature cited in the description

- **M. NAGATANI et al.** Ultrahigh-speed low-power DACs using InP HBTs for beyond-100-Gb/s/ch optical transmission systems. *IEEE Journal of Solid-State Circuits,* October 2011, vol. 46 (10), 2215-2225
- **P. SCHVAN et al.** A 22GS/S 6b DAC with integrated digital ramp generator. *Proc. IEEE Int. Solid-State Circuits Conf. Digest of Technical Papers (ISSCC),* February 2005, 122-588
- **D. BARANAUSKAS et al.** A 0.36W 6b up to 20GS/S DAC for UWB wave formation. *Proc. IEEE Int. Solid-State Circuits Conf. Digest of Technical Papers (ISSCC),* February 2006, 2380-2389
- **T. ELLERMEYER et al.** DA and AD converters in SiGe technology: Speed and resolution for ultra-high data rate applications. *Proc. 36th European Conf Optical Communication (ECOC),* September 2010, 1-6

- **Y. M. GRESHISHCHEV et al.** A 56GS/S 6b DAC in 65nm CMOS with 256x6b memory. *Proc. IEEE Int. Solid-State Circuits Conf. Digest of Technical Papers (ISSCC),* February 2011, 194-196
- **M. KHAFAJI et al.** A 6-bit fully binary digital-to-analogue converter in 0.25-pm SiGe BiCMOS for optical communications. *IEEE Transactions on Microwave Theory and Techniques,* September 2011, vol. 59 (9), 2254-2264
- **M. KHAFAJI et al.** SFDR considerations for current steering high-speed digital to analog converters. *IEEE Bipolar/BiCMOS Circuits and Technology Meeting (BCTM),* September 2012, 1-4
- **J. MERCADO.** *DAC Interleaving in Ultra-High-Speed Arbs*
- **T. REED et al.** Silicon Optical Modulators. *Nature Photonics,* 2010, vol. 4 (8), 518-527